(19) Europäisches Patentamt / European Patent Office / Office européen des brevets

(11) EP 2 299 452 A1

(12) EUROPEAN PATENT APPLICATION
published in accordance with Art. 153(4) EPC

(43) Date of publication:
**23.03.2011 Bulletin 2011/12**

(21) Application number: **09794425.0**

(22) Date of filing: **07.07.2009**

(51) Int Cl.:
***H01B 5/16*** (2006.01) ***H01B 13/00*** (2006.01)
***H01L 21/60*** (2006.01) ***H01R 11/01*** (2006.01)
***H05K 1/14*** (2006.01)

(86) International application number:
**PCT/JP2009/062350**

(87) International publication number:
**WO 2010/004981 (14.01.2010 Gazette 2010/02)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **09.07.2008 JP 2008179013**
**14.08.2008 JP 2008208936**
**10.02.2009 JP 2009028496**

(71) Applicant: **FUJIFILM Corporation**
**Tokyo 106-0031 (JP)**

(72) Inventors:
- **HATANAKA Yusuke**
  **Haibara-gun**
  **Shizuoka 421-0396 (JP)**
- **SUZUKI Shinya**
  **Haibara-gun**
  **Shizuoka 421-0396 (JP)**

(74) Representative: **HOFFMANN EITLE**
**Patent- und Rechtsanwälte**
**Arabellastraße 4**
**81925 München (DE)**

# (54) MICROSTRUCTURE, AND METHOD FOR PRODUCTION THEREOF

(57) A microstructure which has excellent long-term stability and is capable of simple joining by thermocompression bonding at a high joint strength is provided. The microstructure includes an insulating base in which through micropores with a pore size of 10 to 500 nm are disposed at a density of $1 \times 10^6$ to $1 \times 10^{10}$ micropores/mm$^2$. The through micropores are filled with a metal at a filling ratio of at least 30% and a polymer layer is formed on at least one surface of the insulating base.

FIG.2A

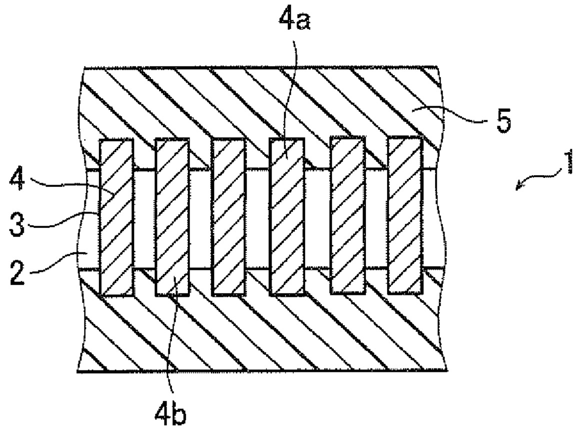


EP 2 299 452 A1

## Description

TECHNICAL FIELD

The present invention relates to a microstructure. More specifically, the invention relates to a microstructure which has excellent long-term stability, is capable of simple joining by thermocompression bonding at a high joint strength, is suitable for use as an anisotropic conductive member, and is made up of an insulating base having through micropores, as well as a method of manufacturing such microstructure.

BACKGROUND ART

An anisotropic conductive member, when inserted between an electronic component such as a semiconductor device and a circuit board, then subjected to merely the application of pressure, is able to provide an electrical connection between the electronic component and the circuit board. Accordingly, such members are highly attractive members that are widely used, for example, as connecting members for semiconductor devices and other electronic components and as inspection connectors when carrying out functional inspections, and that can be expected to be applied to optical transmission materials.

In particular, owing to the remarkable degree of miniaturization that has occurred in electronically connecting members for semiconductor devices and the like, connection stability cannot be fully guaranteed in conventional techniques such as wire bonding that involve the direct connection of a wiring substrate. This situation has drawn attention in recent years to anisotropic conductive members of a type in which an array of electrically conductive elements pass completely through a film of insulating material, or of a type in which metal balls are arranged in a film of insulating material.

Inspection connectors have been developed to avoid the large monetary losses that are incurred when, upon carrying out functional inspections after an electronic component such as a semiconductor device has been mounted on a circuit board, the electronic component is found to be defective and the circuit board is discarded together with the electronic component.

That is, by bringing electronic components such as semiconductor devices into electrical contact with a circuit board through an anisotropic conductive member at positions similar to those to be used during mounting and carrying out functional inspections, it is possible to perform the functional inspections without mounting the electronic components on the circuit board, thus enabling the above problem to be avoided.

An anisotropic conductive member used in such applications is described in Patent Document 1, which discloses "an anisotropic conductive film comprising a film substrate composed of an adhesive insulating material and a plurality of conductive paths composed of a conductive material which are arrayed within the film substrate in a mutually insulated state and pass entirely through the film substrate in a thickness direction thereof, wherein the conductive paths have shapes, in a cross-section parallel to a lengthwise direction of the film substrate, with circumferences having thereon an average maximum length between two points of from 10 to 30 $\mu$m, and wherein neighboring conductive paths have intervals therebetween which are from 0.5 to 3 times the average maximum length."

Patent Document 2 discloses "an anisotropic conductive film comprising a film base composed of an insulating resin and a plurality of conductive paths which are mutually insulated, pass entirely through the film base in a thickness direction thereof and are positioned in staggered rows, wherein conductive paths in mutually neighboring conductive path rows have a smaller distance therebetween than conductive paths within a single row of conductive paths."

Patent Documents 1 and 2 disclose methods of manufacturing such anisotropic conductive films in which fine wires of an anisotropic conductive material are inserted into an insulating film, the elements are integrally united by the application of heat and pressure, and scribing is subsequently carried out in the thickness direction.

Patent Document 3 examines a method of manufacturing an anisotropic conductive film which involves electroforming conductive columns using a resist and a mask, then pouring an insulating material in the columns and solidifying the insulating material.

Patent Document 4 discloses "a method of manufacturing an electrically connecting member having a retaining body made of an electrically insulating material and a plurality of conductive elements provided in a mutually insulating state within the retaining body, wherein an end of each conductive element is exposed on a side of the retaining body and the other end of each conductive element is exposed on the other side of the retaining body, the method comprising:

a first step of exposing a matrix having a base and an insulating layer which, when deposited on the base, forms the retaining body to a high energy beam from the insulating layer side, thereby removing all of the insulating layer and part of the base in a plurality of regions so as to form a plurality of holes in the matrix;

a second step of filling the plurality of formed holes with a conductive material for forming the conductive elements so as to be flush with the sides of the insulating layer or to protrude from the sides; and a third step of removing the base." Patent Document 4 also carries out investigations on various materials (e.g., polyimide resins, epoxy resins

and silicone resins) for the insulating layer.

However, with the increasing trend in recent years toward higher integration, electrode (terminal) sizes in electronic components such as semiconductor devices are becoming smaller, the number of electrodes (terminals) is increasing, and the distance between terminals is becoming smaller. Moreover, there have also appeared electronic components having a surface construction wherein the surface on each of the numerous terminals arranged at a narrow pitch lies at a position that is more recessed than the surface of the component itself.
In order to be able to adapt to such electronic components, there has arisen a need to make the outer diameter (thickness) of the conductive paths in anisotropic conductive members smaller and to arrange the conductive paths at a narrower pitch.
However, in the methods of manufacturing the anisotropic conductive films and electrically connecting members described in Patent Documents 1 to 4, it has been very difficult to reduce the size of the conductive paths, and it has been further difficult to fill a conductive material at a high filling ratio in order to obtain small-sized conductive paths disposed at a narrow pitch.
Therefore, a method of filling a conductive material at a high filling ratio is expected in order to obtain small-sized conductive paths disposed at a narrow pitch.
The anisotropic conductive films as described above are joined to various wiring substrates and used. Exemplary methods that may be commonly used for joining include ultrasonic bonding, solder bonding and metal diffusion bonding by thermocompression and thermocompression bonding is particularly used as a simple joining method. The thermocompression bonding strength only relies on the atomic diffusion of metals and is therefore low. Recently, a method of hardening a reinforcing agent called underfill is commonly used but a simpler thermocompression bonding method exhibiting a high joint strength is expected to be developed because the method of inserting the underfill into the joint portions is complicated.
In addition, the joint material itself is a metal. Therefore, depending on the material used, deterioration due to natural oxidation may occur and the resistance is increased with time.
Patent Document 1: JP 2000-012619 A;
Patent Document 2: JP 2005-085634 A;
Patent Document 3: JP 2002-134570 A;
Patent Document 4: JP 03-182081 A;

DISCLOSURE OF THE INVENTION

PROBLEMS TO BE SOLVED BY THE INVENTION

Accordingly, an object of the invention is to provide a microstructure made up of an insulating base having through micropores, the microstructure having excellent long-term stability, being capable of simple joining by thermocompression bonding at a high joint strength, having a dramatically increased conductive path density, and being usable as an anisotropic conductive member suitable to the narrow pitch that may be used as an inspection connector for electronic components such as semiconductor devices even today when still higher levels of integration have been achieved. Another object of the invention is to provide a method of manufacturing such a microstructure.

MEANS TO SOLVE THE PROBLEMS

The inventors of the invention have made an intensive study to achieve the above objects and as a result found that an improvement in the joint strength after thermocompression bonding and drastic simplification of the joining are achieved by filling a metal into through micropores formed in an insulating base through electrolytic plating and additionally forming a polymer layer on a surface of the insulating base. The invention has been thus completed.
Accordingly, the invention provides the following (i) to (vii).

(i) A microstructure comprising an insulating base in which through micropores with a pore size of 10 to 500 nm are disposed at a density of $1 \times 10^6$ to $1 \times 10^{10}$ micropores/mm$^2$, wherein the through micropores are filled with a metal at a filling ratio of at least 30% and a polymer layer is formed on at least one surface of the insulating base.
(ii) The microstructure according to (i), wherein the insulating base is an alumina base obtained by anodizing aluminum.
(iii) The microstructure according to (i) or (ii), wherein a degree of ordering of the through micropores as defined by formula (I):

$$\text{Degree of ordering (\%)} = B/A \times 100 \quad (1)$$

(wherein A represents a total number of through micropores in a measurement region, and B represents a number of specific through micropores in the measurement region for which, when a circle is drawn so as to be centered on a center of gravity of a specific through micropore and so as to be of a smallest radius that is internally tangent to an edge of another through micropore, the circle includes centers of gravity of six through micropores other than the specific through micropore) is at least 50%.

(iv) The microstructure according to any one of (i) to (iii), wherein the metal filled into the through micropores is exposed at surfaces of the insulating base.

(v) The microstructure according to any one of (i) to (iii), wherein the metal filled into the through micropores is protruded from surfaces of the insulating base.

(vi) A method of manufacturing a microstructure according to any one of (i) to (v), comprising at least:

(1) a treatment for forming an electrode film having no void on one surface of an insulting base in which through micropores with a pore size of 10 to 500 nm are disposed at a density of $1 \times 10^6$ to $1 \times 10^{10}$ micropores/mm$^2$;
(2) a metal filling treatment through electrolytic plating using the electrode film; and
(3) a treatment for forming a polymer layer,
these treatments being performed in this order.

(vii) A structure obtained by linking together a plurality of microstructures according to any one of (i) to (v) via a polymer layer.

EFFECTS OF THE INVENTION

As will be described later, the invention can provide a microstructure which has excellent long-term stability, is capable of simple joining by thermocompression bonding at a high joint strength, has dramatically increased conductive path density and filling ratio of a metal making up the conductive paths, and is suitable to an anisotropic conductive member that may be used as an inspection connector for electronic components such as semiconductor devices even today when still higher levels of integration have been achieved. The invention can also provide a method of manufacturing such a microstructure.

BRIEF DESCRIPTION OF THE DRAWINGS

[FIG. 1] FIGS. 1A and 1B are simplified views of a preferred embodiment of a microstructure of the invention. FIG. 1A is a front view and FIG. 1B is a cross-sectional view taken along the line IB-IB of FIG. 1A. The polymer layer which is one of the components of the microstructure is not shown in FIGS. 1A and 1B.

[FIG. 2] FIGS. 2A to 2C are simplified views of a preferred embodiment of the microstructure of the invention. FIG. 2A is a cross-sectional view taken along the line IB-IB of FIG. 1A, FIG. 2B is a view showing the state before joining an electronic component and the microstructure together by thermocompression bonding, and FIG. 2C is a view showing the state after joining the microstructure and the electronic component together by thermocompression bonding.

[FIG. 3] FIGS. 3A and 3B are diagrams illustrating a method for computing the degree of ordering of micropores.

[FIG. 4] FIGS. 4A to 4D are schematic end views for illustrating metal filling treatment and other treatments in the manufacturing method of the invention.

[FIG. 5] FIGS. 5A and 5B are simplified views of the microstructure obtained in Example 1. FIG. 5A is a front view and FIG. 5B is a cross-sectional view seen from the same direction as in FIG. 1B.

[FIG. 6] FIGS. 6A and 6B are simplified views of the structure obtained in Example 7. FIG. 6A is a front view and FIG. 6B is a cross-sectional view seen from the same direction as in FIG. 1B.

DESCRIPTION OF SYMBOLS

| | |
|---|---|
| 1 | microstructure |

| | |
|---|---|
| 2 | insulating base |
| 3 | through micropore |
| 4 | metal |
| 4a, 4b | protrusion |
| 5 | polymer layer |
| 6 | thickness of the insulating base |
| 7 | width between neighboring through micropores |
| 8 | diameter of the through micropore |
| 9 | center-to-center distance (pitch) between neighboring through micropores |
| 10 | electronic component |
| 11 | joint wiring portion |
| 101, 102, 104, 105, 107, 108 | micropore |
| 103, 106, 109 | circle |

BEST MODE FOR CARRYING OUT the INVENTION

The microstructure and its manufacturing method according to the invention are described below in detail. The microstructure of the invention is made up of an insulating base in which through micropores with a pore size of 10 to 500 nm are disposed at a density of $1 \times 10^6$ to $1 \times 10^{10}$ micropore/mm$^2$, the through micropores being filled with a metal at a filling ratio of at least 30% and a layer made of a polymer (a polymer layer) being formed on at least one surface of the insulating base.

FIGS. 1A and 1B show simplified views of a preferred embodiment of a microstructure of the invention. FIG. 1A is a front view and FIG. 1B is a cross-sectional view taken along the line IB-IB of FIG. 1A. The polymer layer which is one of the components of the microstructure is not shown in FIGS. 1A and 1B. FIG. 2A is similar to FIG. 1A except that the polymer layer of the microstructure is shown. FIGS. 2B and 2C show a procedure for joining the microstructure and an electronic component together by thermocompression bonding in the case of using the microstructure as an anisotropic conductive member. FIG. 2B shows the state before joining the electronic component and the microstructure together by thermocompression bonding, and FIG. 2C shows the state after joining the microstructure and the electronic component together by thermocompression bonding.

As shown in FIGS. 1A and 1B, a microstructure 1 of the invention is made up of an insulating base 2 having through micropores 3, which are filled with a metal 4. In cases where the microstructure 1 of the invention is used as an anisotropic conductive member, the through micropores 3 filled with the metal 4 make up the conductive paths of the anisotropic conductive member.

In cases where the microstructure of the invention is used as the anisotropic conductive member, the metal 4 filled into the through micropores 3 are to be exposed at both surfaces of the insulating base 2. In other words, in cases where the microstructure 1 of the invention is used as the anisotropic conductive member, the metal 4 filled into the through micropores 3 is to be exposed at surfaces 2a and 2b of the insulating base 2. However, as shown in FIG. 1B, the metal 4 filled into the through micropores 3 is preferably protruded from the surfaces 2a and 2b of the insulating base 2 (as shown by 4a and 4b). In this specification, when the metal 4 filled into the through micropores 3 protrudes from both the surfaces 2a and 2b of the insulating base 2, the protrusions (in FIG. 1B, the portions represented by reference symbols 4a and 4b) are referred to below as "bumps."

As shown in FIG. 2A, the microstructure of the invention has a layer 5 made of a polymer (polymer layer) formed on at least one surface of the insulating base 2. However, the polymer layer 5 is preferably formed on each of the surfaces 2a and 2b of the insulating base 2 as shown in FIG. 2A.

The polymer layer 5 formed on at least one surface of the insulating base 2 reinforces the joining between the microstructure 1 and an electronic component 10 by thermocompression bonding, more specifically the joining between the bumps 4a, 4b of the microstructure 1 and joint wiring portions 11 of the electronic component 10 as shown in FIGS. 2B and 2C. The joint strength of the microstructure with the electronic component is thus thought to be improved. Since the polymer layer 5 reinforces the joining, it is not necessary to use an underfill, which enables simpler joining by thermocompression bonding.

Next, the materials and dimensions of the respective components of the microstructure are described.

[Insulating Base]

The insulating base 2 making up the microstructure 1 of the invention has the through micropores 3 with a pore size of 10 to 500 nm which are disposed at a density of $1 \times 10^6$ to $1 \times 10^{10}$ micropores/mm$^2$ The insulating base should have an electric resistivity of $10^{14}$ $\Omega\cdot$cm which is equivalent to that of an insulating base (e.g., a thermoplastic elastomer) making up a conventionally known anisotropic conductive film.

The insulating base is not particularly limited as long as the above requirement is met, but an oxide film formed by anodizing a metal is preferred because independent through micropores 3 with desired pore sizes are obtained and the through micropores 3 obtained have a high aspect ratio, and an alumina substrate obtained by anodizing aluminum is particularly preferred because it has good dimensional stability and is comparatively inexpensive.

In the microstructure 1 of the invention, the through micropores 3 to be filled with the metal 4 are present in a state in which they are mutually isolated by the insulating base 2, and are disposed at a density of $1 \times 10^6$ to $1 \times 10^{10}$ micropores /$mm^2$.

At a density of the through micropores 3 within the foregoing range, the microstructure of the invention can be used as an inspection connector or the like for electronic components such as semiconductor devices even today when still higher levels of integration have been achieved. On the other hand, at a density of the through micropore 3 exceeding the foregoing range, it may be difficult to keep the anisotropic conduction due to impedance characteristics.

The through micropores 3 preferably have a density of $2 \times 10^6$ to $8 \times 10^9$/=$mm^2$ and more preferably $5 \times 10^6$ to $5 \times 10^9$/$mm^2$.

The pore size of the through micropores 3 of the microstructure 1 of the invention (as represented by reference symbol 8 in FIG. 1B) is from 10 to 500 nm.

At a pore size of the through micropores 3 within the foregoing range, when electrical signals are passed through the conductive paths, sufficient responses can be obtained, thus enabling advantageous use of the microstructure 1 of the invention as an inspection connector for electronic components.

The through micropores 3 preferably have a pore size of 20 to 400 nm, more preferably 40 to 200 nm and even more preferably 50 to 100 nm.

From the viewpoint that the density of the through micropores can be increased, the insulating base 2 making up the microstructure 1 of the invention preferably has a degree of ordering of the through micropores 3, as defined by formula (i):

$$\text{Degree of ordering (\%)} = B/A \times 100 \quad \text{(i)}$$

(wherein A represents the total number of through micropores in a measurement region, and B represents the number of specific through micropores in the measurement region for which, when a circle is drawn so as to be centered on the center of gravity of a specific through micropore and so as to be of the smallest radius that is internally tangent to the edge of another through micropore, the circle includes the centers of gravity of six through micropores other than the specific through micropore) of at least 50%.

FIG. 3A and 3B are diagrams illustrating the method for computing the degree of ordering of the through micropores. Above formula (1) is explained more fully below by reference to FIGS. 3A and 3B.

In the case of a first through micropore 101 shown in FIG. 3A, when a circle 103 is drawn so as to be centered on the center of gravity of the first through micropore 101 and so as to be of the smallest radius that is internally tangent to the edge of another through micropore (inscribed in a second through micropore 102), the interior of the circle 103 includes the centers of gravity of six through micropores other than the first through micropore 101. Therefore, the first through micropore 101 is included in B.

In the case of another first through micropore 104 shown in FIG. 3B, when a circle 106 is drawn so as to be centered on the center of gravity of the first through micropore 104 and so as to be of the smallest radius that is internally tangent to the edge of another through micropore (inscribed in a second through micropore 105), the interior of the circle 106 includes the centers of gravity of five through micropores other than the first through micropore 104. Therefore, the first through micropore 104 is not included in B.

In the case of yet another first through micropore 107 shown in FIG. 3B, when a circle 109 is drawn so as to be centered on the center of gravity of the first through micropore 107 and so as to be of the smallest radius that is internally tangent to the edge of another through micropore (inscribed in a second through micropore 106), the interior of the circle 109 includes the centers of gravity of seven through micropores other than the first through micropore 107. Therefore, the first through micropore 107 is not included in B.

The insulating base 2 making up the microstructure 1 of the invention preferably has a thickness (as represented in FIG. 1B by reference symbol 6) of from 30 to 300 μm, and more preferably from 50 to 100 μm. At an insulating base thickness within the foregoing range, the insulating base can be handled with ease.

Moreover, in the insulating base 2 making up the microstructure 1 of the invention, the width between neighboring through micropores 3 (represented in FIG. 1B by reference symbol 7) is preferably at least 10 nm, more preferably from 20 to 100 nm, and even more preferably from 20 to 50 nm. At a width between neighboring through micropores 3 of the insulating base 2 to be filled with the metal 4 within the foregoing range, the insulating base 2 functions fully as an

insulating barrier.

Moreover, in the microstructure 1 of the invention, the center-to-center distance between neighboring through micropores 3 (as represented in FIGS. 1A and 1B by reference symbol 9; also referred to below as "pitch") is preferably from 20 to 500 nm, more preferably from 40 to 200 nm, and even more preferably from 50 to 140 nm. At a pitch within the foregoing range, a balance is easily struck between the diameter of each of the through micropores 3 and the width between neighboring through micropores 3 (insulating barrier thickness).

[Metal]

The metal 4 filled into the through micropores 3 in the microstructure 1 of the invention is not particularly limited as long as the metal used has an electric resistivity of not more than $10^3$ Ω·cm. Illustrative examples of the metal that may be preferably used include gold (Au), silver (Ag), copper (Cu), aluminum (Al), magnesium (Mg), nickel (Ni), molybdenum (Mo), iron (Fe), palladium (Pd), beryllium (Be), rhenium (Re) and tungsten (W). One of these metals, or an alloy of two or more of the metals may be filled into the through micropores 3.

Of these, in terms of electric conductivity, copper, gold, aluminum and nickel are preferred, and copper and gold are more preferred.

In terms of cost, it is more preferable to use other materials than gold (e.g., copper) as the metal 4 to be filled into the through micropores 3 and to use gold only for forming the surfaces of the paths exposed at or protruded from both the surfaces of the insulating base 2 (hereinafter also referred to as "end faces").

In the microstructure 1 shown in FIGS. 1A and 1B, all the through micropores 3 present in the insulating base 2 are filled with the metal 4, which is, however, not necessarily required, provided the ratio of the number of through micropores 3 filled with the metal 4 to the number of the through micropores 3 present in the insulating base 2 of the microstructure 1 of the invention, that is, the filling ratio of the metal 4 is at least 30%.

The filling ratio of the metal 4 can be determined by observing the surface of the insulating base 2 by SEM and calculating the ratio of the number of through micropores 3 filled with the metal 4 to the number of all the through micropores 3 within the field of view.

In cases where the microstructure 1 of the invention is used as an anisotropic conductive member, of the through micropores 3 present in the insulating base 2, those which are not filled with the metal 4 cannot serve as the conductive paths and are defects in the anisotropic conductive member.

The microstructure of the invention has a metal filling ratio of at least 30%. Therefore, when used as an anisotropic conductive member, the anisotropic conductive member is an excellent member having few defects if the joint wiring portions 11 of the electronic component 10 have a size of at least 1 μm. The joint wiring portions of the electronic component typically have a size of at least 30 μm.

The microstructure of the invention preferably has a metal filling ratio of at least 50% and more preferably at least 70%. Of the through micropores 3 present in the insulating base 2, those which are not filled with the metal 4 will be filled with a polymer making up the polymer layer 5 during polymer layer-forming treatment to be described later.

In cases where the microstructure 1 of the invention has the bumps 4a and 4b, the bumps 4a and 4b preferably have a height of 1 to 1000 nm and more preferably 5 to 500 nm. At a height of the bumps 4a and 4b within this range, connectivity with the joint wiring portions 11 of the electronic component 10 is improved.

[Polymer Layer]

The type of the polymer used for the polymer layer 5 is not particularly limited. Examples of the polymer that may be used for the polymer layer 5 include polyethylenes, polypropylenes, poly-4-methylpentene, ionomers such as ethylene ionomers, polyvinyl chlorides, polyvinylidene chlorides, vinyl acetate resins, ABS resins, polystyrene resins, AS resins, methacrylic resins, polyvinyl alcohols, EVA resins, cellulose plastics, thermoplastic elastomers such as polystyrene-type, polyolefin-type, polyvinyl chloride-type, polyurethane-type, polyester-type and polyamide-type thermoplastic elastomers, epoxy resins, unsaturated polyester resins, phenol resins, urea-melamine resins, polyurethane resins, silicone resins, polyacrylic resins, polyamide resins, polyacetals, polycarbonates, modified polyphenylene ethers, thermoplastic polyester resins, polytetrafluoroethylenes, fluororesins, polyphenylene sulfides, polysulfones, amorphous polyarylates, polyether imides, polyether sulfones, polyether ketones, liquid crystal polyesters, polyamide-imides, polyimides and other super engineering plastic resins and polymer alloys. Of these, epoxy resins commonly used for the underfill are preferred.

The thickness of the polymer layer 5 is determined based on the balance between the joint strength and the conductivity upon joining of the microstructure 1 to the electronic component 10 by thermocompression bonding, and is preferably from 0.1 to 5000 μm, more preferably from 0.5 to 3000 μm and most preferably from 1 to 1000 μm.

As shown in FIGS. 2A and 2B, in the microstructure 1 before being joined to the electronic component 10 having the joint wiring portions 11 by thermocompression bonding, the bumps 4a and 4b are covered with the polymer layer 5.

Such a configuration can prevent the metal making up the bumps 4a and 4b from being deteriorated or damaged due to natural oxidation before the joining by thermocompression bonding.
When the microstructure is joined to the electronic component 10 having the joint wiring portions 11 by thermocompression bonding, a force is applied in the directions of arrows shown in FIG. 2B to compress the polymer layer 5, thus enabling the microstructure to be joined to the joint wiring portions 11 of the electronic component 10 via the exposed bumps 4a and 4b as shown in FIG. 2C.
In cases where the microstructure has no bumps and the metal 4 filled into the through micropores 3 are exposed at the surfaces 2a and 2b of the insulating base 2, the electronic component 10 used should be of a configuration in which the joint wiring portions 11 are protruded. In such a case, when the microstructure is joined to the electronic component 10 having the joint wiring portions 11 by thermocompression bonding, a force is applied in the directions of arrows shown in FIG. 2B to compress the polymer layer 5, thus enabling the metal 4 exposed at the surfaces 2a and 2b of the insulating base 2 to be joined to the joint wiring portions 11 of the electronic component 10.

The above-described polymer layer 5 may contain a conductive material in terms of further improving the joint strength. The "conductive material" as used herein refers to a material having electrical conductivity and contributing to electrical conduction in the polymer layer 5 by being incorporated therein. The conductive material is not particularly limited as long as it has electrical conductivity. The conductive material is preferably a metal material and more preferably copper, gold, aluminum or nickel and most preferably copper or gold in terms of its excellent electrical conductivity.
In cases where the conductive material is to be incorporated in the polymer layer 5, the conductive material is preferably in the shape of mutually independent particles or in a columnar shape in the depth direction in order to exhibit anisotropic conduction (property that electrical conduction is established not in the horizontal direction but in the depth direction) in the polymer layer 5 when the microstructure 1 is joined to the electronic component 10 by thermocompression bonding.
In order to ensure the function of the anisotropic conduction, the conductive material in the shape of particles preferably has a particle size of 0.005 μm to 500 μm, more preferably 0.01 μm to 100 μm and most preferably 0.02 μm to 50 μm. The conductive material in a columnar shape preferably has a diameter of 5 nm to 500 μm, more preferably 10 nm to 100 μm and most preferably 20 nm to 50 μm, and a length of 0.1 μm to 5000 μm, more preferably 0.5 μm to 3000 μm and most preferably 1 μm to 1000 μm.
In order to ensure the function of the anisotropic conduction, the conductive material is preferably incorporated in an amount of 1 to 70%, more preferably 3 to 50% and most preferably 5 to 30% in terms of volume ratio with respect to the polymer material making up the polymer layer 5.

The microstructure of the invention can be obtained by the inventive method of manufacturing microstructures to be described later. This method is also hereinafter referred to simply as the "inventive manufacturing method."

The inventive manufacturing method includes at least:

(1) a treatment for forming an electrode film having no void on one surface of an insulting base in which through micropores with a pore size of 10 to 500 nm are disposed at a density of $1 \times 10^6$ to $1 \times 10^{10}$ micropores/mm$^2$ (electrode film-forming treatment);
(2) a metal filling treatment through electrolytic plating (metal filling treatment); and
(3) a treatment for forming a polymer layer,

these treatments being performed in this order.

The insulating base having the through micropores is preferably an alumina base obtained by anodizing aluminum as described above.
In cases where the alumina base obtained by anodizing aluminum is used as the insulating base having the through micropores, the insulating base can be obtained by subjecting an aluminum substrate at least to, in order,
treatment (A) in which a micropore-bearing oxide film is formed by anodization (anodizing treatment);
treatment (B) in which aluminum is removed from the oxide film obtained by treatment (A) (aluminum removal treatment); and
treatment (C) in which micropores present in the oxide film from which aluminum has been removed by treatment (B) are made to penetrate therethrough (perforating treatment).

Next, the aluminum substrate that may be used to manufacture the insulating base having the through micropores according to the procedure described above, and each treatment carried out on the aluminum substrate are described in detail.

[Aluminum Substrate]

The aluminum substrate is not subject to any particular limitation. Illustrative examples include pure aluminum plate; alloy plates composed primarily of aluminum and containing trace amounts of other elements; substrates made of low-purity aluminum (e.g., recycled material) on which high-purity aluminum has been vapor-deposited; substrates

such as silicon wafers, quartz or glass whose surface has been covered with high-purity aluminum by a process such as vapor deposition or sputtering; and resin substrates on which aluminum has been laminated.

In the practice of the invention, of the aluminum substrate, the surface to be subjected to anodizing treatment to be described later has an aluminum purity of preferably at least 99.5 wt%, more preferably at least 99.9 wt% and even more preferably at least 99.99 wt%. An aluminum purity within the foregoing range is preferred because the micropores are sufficiently independent of each other to retain the independence when a metal is filled into the through micropores obtained by perforating the micropores and to eliminate adverse effects of leakage current when the microstructure of the invention is used as the anisotropic conductive member.

In the practice of the invention, the surface of the aluminum substrate on which the subsequently described anodizing treatment is to be carried out is preferably subjected beforehand to degreasing treatment and mirror-like finishing treatment. The aluminum substrate surface is more preferably subjected to heat treatment in order to improve the independence of the micropores.

[Heat Treatment]

Heat treatment is preferably carried out at a temperature of from 200 to 350°C for a period of about 30 seconds to about 2 minutes. More specifically, an exemplary method involves putting an aluminum substrate in a heated oven. Such a heat treatment improves the independence of the micropores formed by anodizing treatment to be described later. Following heat treatment, it is preferable to rapidly cool the heat-treated aluminum substrate. The method of cooling is exemplified by a method involving direct immersion of the aluminum substrate in water or the like.

[Degreasing Treatment]

Degreasing treatment is carried out with a suitable substance such as an acid, alkali or organic solvent so as to dissolve and remove organic substances, including dust, grease and resins, adhering to the aluminum substrate surface, and thereby prevent defects due to organic substances from arising in each of the subsequent treatments.

Preferred degreasing methods include the following: a method in which an organic solvent such as an alcohol (e.g., methanol), ketone (e.g., methyl ethyl ketone), petroleum benzin or volatile oil is contacted with the surface of the aluminum substrate at ambient temperature (organic solvent method); a method in which a liquid containing a surfactant such as soap or a neutral detergent is contacted with the surface of the aluminum substrate at a temperature of from ambient temperature to 80°C, after which the surface is rinsed with water (surfactant method); a method in which an aqueous sulfuric acid solution having a concentration of 10 to 200 g/L is contacted with the surface of the aluminum substrate at a temperature of from ambient temperature to 70°C for a period of 30 to 80 seconds, following which the surface is rinsed with water; a method in which an aqueous solution of sodium hydroxide having a concentration of 5 to 20 g/L is contacted with the surface of the aluminum substrate at ambient temperature for about 30 seconds while electrolysis is carried out by passing a direct current through the aluminum substrate surface as the cathode at a current density of 1 to 10 $A/dm^2$, following which the surface is contacted with an aqueous solution of nitric acid having a concentration of 100 to 500 g/L and thereby neutralized; a method in which any of various known anodizing electrolytic solutions is contacted with the surface of the aluminum substrate at ambient temperature while electrolysis is carried out by passing a direct current at a current density of 1 to 10 $A/dm^2$ through the aluminum substrate surface as the cathode or by passing an alternating current through the aluminum substrate surface as the cathode; a method in which an aqueous alkali solution having a concentration of 10 to 200 g/L is contacted with the surface of the aluminum substrate at 40 to 50°C for 15 to 60 seconds, following which an aqueous solution of nitric acid having a concentration of 100 to 500 g/L is contacted with the surface and thereby neutralized; a method in which an emulsion prepared by mixing a surfactant, water and the like into an oil such as gas oil or kerosene is contacted with the surface of the aluminum substrate at a temperature of from ambient temperature to 50°C, following which the surface is rinsed with water (emulsion degreasing method); and a method in which a mixed solution of, for example, sodium carbonate, phosphates and surfactant is contacted with the surface of the aluminum substrate at a temperature of from ambient temperature to 50°C for 30 to 180 seconds, following which the surface is rinsed with water (phosphate method).

Of these, the organic solvent method, surfactant method, emulsion degreasing method and phosphate method are preferred from the standpoint of removing grease from the aluminum surface while causing substantially no aluminum dissolution.

Known degreasers may be used in degreasing treatment. For example, degreasing treatment may be carried out using any of various commercially available degreasers by the prescribed method.

[Mirror-Like Finishing Treatment]

Mirror-like finishing treatment is carried out to eliminate surface topographic features of the aluminum substrate

(e.g., rolling streaks formed during rolling of the aluminum substrate) and improve the uniformity and reproducibility of sealing treatment using, for example, electrodeposition.
In the practice of the invention, mirror-like finishing treatment is not subject to any particular limitation, and may be carried out using any suitable method known in the art. Examples of suitable methods include mechanical polishing, chemical polishing, and electrolytic polishing.
Illustrative examples of suitable mechanical polishing methods include polishing with various commercial abrasive cloths, and methods that combine the use of various commercial abrasives (e.g., diamond, alumina) with buffing. More specifically, a method which is carried out with an abrasive while changing over time the abrasive used from one having coarser particles to one having finer particles is appropriately illustrated. In such a case, the final abrasive used is preferably one having a grit size of 1500. In this way, a glossiness of at least 50% (in the case of rolled aluminum, at least 50% in both the rolling direction and the transverse direction) can be achieved.
Examples of chemical polishing methods include various methods mentioned in the 6th edition of Aluminum Handbook (Japan Aluminum Association, 2001), pp. 164-165.
Preferred examples include phosphoric acid/nitric acid method, Alupol method, Alupol V method, Alcoa R5 method, $H_3PO_4$-$CH_3COOH$-Cu method and $H_3PO_4$-$HNO_3$-$CH_3COOH$ method. Of these, the phosphoric acid/nitric acid method, the $H_3PO_9$-$CH_3COOH$-Cu method and the $H_3PO_4$-$HNO_3$-$CH_3COOH$ method are especially preferred.
With chemical polishing, a glossiness of at least 70% (in the case of rolled aluminum, at least 70% in both the rolling direction and the transverse direction) can be achieved.
Examples of electrolytic polishing methods include various methods mentioned in the 6th edition of Aluminum Handbook (Japan Aluminum Association, 2001), pp. 164-165; the method described in US 2,708,655; and the method described in Jitsumu Hyomen Gijutsu (Practice of Surface Technology), Vol. 33, No. 3, pp. 32-38 (1986).
With electrolytic polishing, a glossiness of at least 70% (in the case of rolled aluminum, at least 70% in both the rolling direction and the transverse direction) can be achieved.
These methods may be suitably combined and used. In an illustrative method that may be preferably used, mechanical polishing which is carried out by changing the abrasive over time from one having coarser particles to one having finer particles is followed by electrolytic polishing.
Mirror-like finishing treatment enables a surface having, for example, a mean surface roughness $R_a$ of 0.1 $\mu$m or less and a glossiness of at least 50% to be obtained. The mean surface roughness $R_a$ is preferably 0.03 $\mu$m or less, and more preferably 0.02 $\mu$m or less. The glossiness is preferably at least 70%, and more preferably at least 80%.
The glossiness is the specular reflectance which can be determined in accordance with JIS 28741-1997 (Method 3: 60° Specular Gloss) in a direction perpendicular to the rolling direction. Specifically, measurement is carried out using a variable-angle glossmeter (e.g., VG-1D, manufactured by Nippon Denshoku Industries Co., Ltd.) at an angle of incidence/reflection of 60° when the specular reflectance is 70% or less, and at an angle of incidence/reflection of 20° when the specular reflectance is more than 70%.

(A) Anodizing Treatment

In treatment (A), the aluminum substrate is anodized to form a micropore-bearing oxide film at the surface of the aluminum substrate.
Any conventionally known method may be used for anodizing treatment. When the microstructure of the invention is used as an anisotropic conductive member, it is important for the micropore to be independent of each other, and therefore anodizing treatment is preferably performed according to any of the self-ordering methods described in JP 3,714,507 B, JP 2002-285382 A, JP 2006-124827 A, JP 2007-204802 A, JP 2007-231339 A, JP 2007-231405 A, JP 2007-231340 A, JP 2007-231340 A, and JP 2007-238988 A. These treatments are preferably those described under the treatment conditions in the foregoing patent and published patent applications.
Other processes for forming independent micropores include, for example, processes which use imprinting (transfer processes and press patterning processes in which a plate or roll having projections thereon is pressed against the aluminum substrate to form pits at the substrate). A specific example is a process in which a plate having numerous projections on a surface thereof is pressed against the aluminum substrate surface, thereby forming pits. For example, the process described in JP 10-121292 A may be used.
There is also a process in which polystyrene spheres are densely arranged on the surface of the aluminum substrate, $SiO_2$ is vapor-deposited onto the spheres, then the polystyrene spheres are removed and the substrate is etched using the vapor-deposited $SiO_2$ as the mask, thereby forming pits.
Another exemplary process is a particle beam process. In the particle beam process, pits are formed by irradiating the surface of the aluminum substrate with a particle beam. This process has the advantage that the positions of the pits can be controlled as desired.
Examples of the particle beam include a charged particle beam, a focused ion beam (FIB), and an electron beam.
For example, the process described in JP 2001-105400 A may be used as the particle beam process.

A block copolymer process may also be used. The block copolymer process involves forming a block copolymer layer on the surface of the aluminum substrate, forming an islands-in-the-sea structure in the block copolymer layer by thermal annealing, then removing the island components to form pits.
For example, the process described in JP 2003-129288 A may be used as the block copolymer method.
A resist patterning/exposure/etching process may also be used. In the resist patterning/exposure/etching process, a resist film formed on the surface of the aluminum substrate is exposed and developed by photolithography or electron beam lithography to form a resist pattern. The resist is then etched to form pits which pass entirely through the resist to the surface of the aluminum substrate.
in the case of using such processes as imprinting process, particle beam process, block copolymer process and resist patterning/exposure/etching process, these treatments for giving starting points for electrolysis to the aluminum substrate surface are followed by anodizing treatment to enable an oxide film having independent micropores to be formed at the surface of the aluminum substrate.

(B) Aluminum Removal Treatment

Treatment (B) dissolves and removes the aluminum substrate from the oxide film obtained by the above-described treatment (A).
A treatment solution which does not readily dissolve the oxide film (alumina) but readily dissolves aluminum is used for dissolution of the aluminum substrate.
That is, use is made of a treatment solution which has an aluminum dissolution rate of at least 1 $\mu$m/min, preferably at least 3 $\mu$m/min, and more preferably at least 5 $\mu$m/min, and has an oxide film (alumina) dissolution rate of 0.1 nm/min or less, preferably 0.05 nm/min or less, and more preferably 0.01 nm/min or less.
Specifically, a treatment solution which includes at least one metal compound having a lower ionization tendency than aluminum, and which has a pH of 4 or less or 8 or more, preferably 3 or less or 9 or more, and more preferably 2 or less or 10 or more is used.
Such a treatment solution is not particularly limited if it does not dissolve the oxide film (alumina) but dissolves aluminum. Examples thereof include aqueous solutions of silver chloride, a bromine/methanol mixture, a bromine/ethanol mixture, aqua regia, and a hydrochloric acid/copper chloride mixture.
The concentration is preferably from 0.01 to 10 mol/L and more preferably from 0.05 to 5 mol/L.
The treatment temperature is preferably from -10 to 80°C and more preferably from 0 to 60°C.
Dissolution of the aluminum substrate is carried out by bringing the aluminum substrate having undergone treatment (A) into contact with the above-described treatment solution. Examples of the contacting method include, but are not limited to, immersion and spraying. Of these, immersion is preferred. The period of contact in this process is preferably from 10 seconds to 5 hours, and more preferably from 1 minute to 3 hours.
The oxide film after dissolution of the aluminum substrate preferably has a thickness of 1 to 1000 $\mu$m and more preferably 10 to 500 $\mu$m.
After the dissolution of the aluminum substrate, the oxide film is preferably rinsed with water before making micropores penetrate therethrough by the procedure described below. The oxide film is preferably rinsed with water at a temperature of 30°C or less in order to suppress changes in the micropore size due to hydration.

(C) Perforating Treatment

The micropores present in the oxide film from which the aluminum substrate has been removed by treatment (B) is subjected to treatment (C) to remove only the bottom of the oxide film to make the micropores present in the oxide film penetrate therethrough. FIG. 4A shows the oxide film (insulating base 2) having the through micropores 3 obtained by this treatment.
This treatment is carried out by bringing only the bottom of the oxide film into contact with an aqueous acid solution or an aqueous alkali solution. Removal of the bottom of the oxide film causes the micropores to penetrate therethrough (to form the through micropores).
It is preferable for at least 70%, more preferably at least 85% and even more preferably at least 95% of the micropores present in the oxide film to penetrate therethrough by this treatment.
The bottom of the oxide film is preferably removed by the method that involves previously immersing the oxide film in a pH buffer solution to fill the micropores with the pH buffer solution from the micropore opening side, and bringing the surface opposite from the openings (i.e., the bottom of the oxide film) into contact with an aqueous acid solution or aqueous alkali solution.
When this treatment is to be carried out with an aqueous acid solution, it is preferable to use an aqueous solution of an inorganic acid such as sulfuric acid, phosphoric acid, nitric acid or hydrochloric acid, or a mixture thereof. The aqueous acid solution preferably has a concentration of to 10 wt%. The aqueous acid solution preferably has a

temperature of 25 to 40°C.

When this treatment is to be carried out with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 wt%. The aqueous alkali solution preferably has a temperature of 20 to 35 °C.

Specific examples of solutions that may be preferably used include a 40°C aqueous solution containing 50 g/L of phosphoric acid, a 30°C aqueous solution containing 0.5 g/L of sodium hydroxide, and a 30°C aqueous solution containing 0.5 g/L of potassium hydroxide.

The time of immersion in the aqueous acid solution or aqueous alkali solution is preferably from 8 to 120 minutes, more preferably from 10 to 90 minutes and even more preferably from 15 to 60 minutes.

Following perforation treatment of the micropores, the oxide film preferably has a thickness of from 1 to 1,000 μm and more preferably from 10 to 500 μm.

Following perforating treatment of the micropores, the oxide film is rinsed with water. The oxide film is preferably rinsed with water at a temperature of 30°C or less in order to suppress changes in the size of the through micropores due to hydration.

Any other treatment process than the above-described treatment process may be used in perforating treatment as long as the micropores formed by treatment (A) can be made to penetrate through the oxide film. In the above-described treatment process, treatment (A) forms the micropore-bearing oxide film on the aluminum substrate; treatment (B) dissolves the aluminum substrate; and treatment (C) partially dissolves the oxide film to remove the bottom of the oxide film thereby making the micropores penetrate through the oxide film. However, a treatment process in which the aluminum substrate is removed while at the same time the micropores are made to penetrate through the oxide film may instead be used. To be more specific, an illustrative method that may be preferably used includes one that involves physically removing the lower portion of the oxide film formed by treatment (A), that is, the portion of the oxide film on the aluminum substrate side through cutting with a laser or by various other polishing treatments to thereby form a through micropore-bearing oxide film.

Next, electrode film-forming treatment and metal filling treatment in the inventive manufacturing method are described in detail.

[Electrode Film-Forming Treatment]

Electrode film-forming treatment is a treatment which is carried out after treatment (C) to form an electrode film having no voids on one surface of the oxide film bearing the through micropores.

The oxide film has on its surface openings of the through micropores but, by carrying out this treatment to form the electrode film having no voids on the surface of the oxide film, the openings are covered with the electrode film.

There is no particular limitation on the method of forming the electrode film as long as the electrode film having no voids can be formed on one surface of the oxide film bearing the through micropores. Specific examples of the forming method include electroless plating of a conductive material such as metal and direct application of a conductive material such as metal. Of these, electroless plating is preferable in terms of the uniformity of the electrode film and the ease of operation.

When electroless plating is used for electrode film-forming treatment, it is necessary to form plating nuclei on one surface of the oxide film. More specifically, a method is preferably used in which a metal or metal compound of the same type as a specific metal to be provided by electroless plating or a metal or metal compound having a higher ionization tendency than a specific metal to be provided by electroless plating is provided on one surface of the oxide film. Exemplary methods of providing such metal or metal compound include vapor deposition and direct application, but the invention is not particularly limited to these methods.

After the plating nuclei have been provided as described above, the electrode film is formed by electroless plating. Immersion is a preferable treatment method from the viewpoint that the thickness of the electrode layer can be controlled by the time.

Use may be made of any conventionally known types of electroless plating solution. The concentration is preferably in a range of from to 300 g/L and more preferably from 100 to 200 g/L.

Noble metal-containing plating solutions such as a gold plating solution, a copper plating solution and a silver plating solution are preferable in terms of increasing the electrical conductivity of the electrode film to be formed, and a gold plating solution is more preferable in terms of the long-term stability of the electrode, that is, the prevention of the deterioration due to oxidation.

The electrode film formed preferably has a thickness of from 0.05 μm to 100 μm, more preferably from 0.1 μm to 50 μm, and even more preferably from 0.2 μm to 20 μm. The electrode film may not have sufficient electrical conductivity at a smaller thickness than the foregoing range, and more time may be required for its formation at a thickness exceeding the foregoing range.

The treatment temperature and the treatment time of electroless plating depend on the thickness of the electrode that

may be formed, and the treatment is preferably carried out at 0°C to 90°C for 1 minute to 10 hours, more preferably at 5°C to 75°C for 10 minutes to 7 hours, and even more preferably at 10°C to 60°C for 30 minutes to 5 hours.

[Metal Filling Treatment]

Metal filling treatment is a treatment in which, following the above-described electrode film-forming treatment, electrolytic plating using the electrode film formed is carried out to fill the interior of the through micropores of the oxide film with a metal as a conductive material.
Here, the same materials as those described above in connection with the microstructure of the invention may be used for metal filling.
In the inventive manufacturing method, electrolytic plating is used for metal filling.
In the inventive manufacturing method, the electrode film having no void that was formed on one surface of the oxide film is used to carry out electrolytic plating, so a metal can be filled into the through micropores present in the oxide film at a high filling ratio.
in a conventionally known electrolytic plating process that is used for coloring or other purposes, it is difficult to selectively deposit (grow) a metal inside micropores at a high aspect ratio, presumably because the deposited metal is consumed within the through micropores and the plating does not grow even when electrolysis is carried out for at least a fixed period of time.
Therefore, in the inventive manufacturing method, when metal filling is carried out by electrolytic plating, it is preferred to provide rest periods during pulse electrolysis or constant potential electrolysis. The rest periods must be at least 10 seconds, and are preferably from 30 to 60 seconds.
To promote stirring of the electrolytic solution, it is desirable to apply ultrasound energy.
Moreover, the electrolysis voltage is generally not more than 20 V, and preferably not more than 10 V, although it is preferable to first measure the deposition potential of the target metal in the electrolytic solution to be used and carry out constant potential electrolysis at that potential + not more than 1V. When carrying out constant potential electrolysis, it is desirable to use also cyclic voltammetry. To this end, use may be made of potentiostats such as those available from Solartron, BAS Inc., Hokuto Denko Corporation and Ivium Technologies.
A conventionally known plating solution may be used.
More specifically, when copper is to be deposited, an aqueous solution of copper sulfate may generally be used. The concentration of copper sulfate is preferably from 1 to 300 g/L, and more preferably from 100 to 200 g/L. Deposition can be promoted by adding hydrochloric acid to the electrolytic solution. In such a case, the concentration of hydrochloric acid is preferably from 10 to 20 g/L.
It is desirable to use a solution of tetrachloroauric acid in sulfuric acid to deposit gold and a nickel chloride bath or a nickel sulfate bath to deposit nickel.
Any of DC plating and AC plating may be used for the deposition by electroplating. In cases where a metal is to be deposited by DC plating, a method in which at least one selected from the group consisting of potential, temperature, metallic ion concentration in the plating bath, and the flow rate of the plating solution is changed during the plating treatment to gradually increase the current value to thereby perform plating treatment is preferred because the metal can be filled at a higher aspect ratio.
It is preferable in electrolytic plating to preliminarily hydrophilize the inner surfaces of the through micropores so that the through micropores are more easily filled with a plating solution. In this case, an illustrative example of the method that may be preferably used includes a silicate treatment which involves providing elemental silicon to the inner surfaces of the through micropores.
The method of providing elemental silicon to the inner surfaces of the through micropores is not subject to any particular limitation, although a commonly used method of treatment involves direct immersion in an aqueous solution in which an alkali metal silicate is dissolved. The thickness of the protective film can be adjusted by varying the ratio between the silicate ingredients silicon dioxide $SiO_2$ and alkali metal oxide $M_2O$ (generally represented as the molar ratio $[SiO_2]/[M_2O]$) and the concentrations thereof in the aqueous solution of an alkali metal silicate.
It is especially preferable here to use sodium or potassium as M.
The molar ratio $[SiO_2]/[M_2O]$ is preferably from 0.1 to 5.0, and more preferably from 0.5 to 3.0.
The $SiO_2$ content is preferably from 0.1 to 20 wt%, and more preferably from 0.5 to 10 wt%.
Following the above-described metal filling treatment, the electrode film is removed from the surface of the oxide film. FIG. 4B shows the state in which the metal 4 is filled into the through micropores 3 of the oxide film (insulating base 2) by the metal filling treatment.
The inventive manufacturing method is capable of filling a metal into the through micropores present in the oxide film at a high filling ratio with respect to the through micropores of at least 30%, preferably at least 50% and more preferably at least 70%.
Surface planarization to be described below is preferably carried out to remove the electrode film from the oxide film

surface.

[Surface Planarization Treatment]

In the inventive manufacturing method, the above-described metal filling treatment is preferably followed by chemical mechanical polishing (CMP) to carry out surface planarization whereby the front side and the back side of the oxide film are planarized.
By carrying out surface planarization, the electrode film formed on one surface of the oxide film is removed. The front and back sides of the oxide film after the through micropores have been filled with a metal can be planarized while removing excess metal adhering to the surfaces.
CMP treatment may be carried out using a CMP slurry such as PLANERLITE-7000 available from Fujimi Inc., GPX HSC800 available from Hitachi Chemical Co., Ltd., or CL-1000 available from AGC Seimi Chemical Co., Ltd.
Mechanical polishing may be used for surface planarization. In this case, CMP may be combined with mechanical polishing or mechanical polishing may only be carried out. When surface planarization is carried out by mechanical polishing, a method is preferably used in which an object to be subjected to surface planarization is polished under load using sandpaper attached to a rotary table or an abrasive cloth having an abrasive applied thereto with the object being bonded with wax or an adhesive to a sample holder such as a highly flat metal plate or a ceramic plate.
In terms of the durability, for examples, a ceramic tool (manufactured by Kemet Japan Co., Ltd.) may be employed as the sample holder for use in mechanical polishing. Exemplary materials that may be preferably used to bond an object to be subjected to surface planarization to the sample holder include waxes in terms of ease of attachment/detachment. For example, use may be made of ALCOWAX and AQUAWAX (both available from Nikka Seiko Co., Ltd.). Since the object to be polished is made of alumina, an abrasive containing diamond abrasive grains is preferably used, and for example, DP-suspension P-6 μm•3μm•1μm•1/4μm (available from Struers) may be used as desired.

[Trimming Treatment]

In cases where the microstructure of the invention is used as an anisotropic conductive member, the above-described metal filling treatment is preferably followed by trimming. However, before starting trimming, it is necessary to remove the electrode film from the oxide film having undergone metal filling treatment. In cases where metal filling treatment is followed by surface planarization, trimming needs to be carried out after this surface planarization.
Trimming is a treatment in which only part of the oxide film is removed from the insulating base from which the electrode film has been removed after metal filling treatment (from the insulating base having undergone surface planarization if this treatment was performed) to protrude the metal filled into the through micropores from the oxide film.
This trimming yields an insulating base in which the metal 4 filled into the through micropores 3 protrudes from the surface of the oxide film (insulating base) (FIG. 4C).
Trimming is carried out by bringing the oxide film into contact with an aqueous acid solution or an aqueous alkali solution under the condition that the metal filled into the through micropores are not dissolved. Examples of the contacting method include, but are not limited to, immersion and spraying. Of these, immersion is preferred.
When this treatment is to be carried out with an aqueous acid solution, it is preferable to use an aqueous solution of an inorganic acid such as sulfuric acid, phosphoric acid, nitric acid or hydrochloric acid, or a mixture thereof. It is particularly preferable to use an aqueous solution containing no chromic acid in terms of its high degree of safety. The aqueous acid solution preferably has a concentration of 1 to 10 wt%. The aqueous acid solution preferably has a temperature of 25 to 60°c.
When this treatment is to be carried out with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 wt%. The aqueous alkali solution preferably has a temperature of 20 to 35°C.
Specific examples of solutions that may be preferably used include a 40°C aqueous solution containing 50 g/L of phosphoric acid, a 30°C aqueous solution containing 0.5 g/L of sodium hydroxide, and a 30°C aqueous solution containing 0.5 g/L of potassium hydroxide. A method that uses an aqueous phosphoric acid solution with which the dissolution rate is readily controlled is particularly preferred.
The time of immersion in the aqueous acid solution or aqueous alkali solution is preferably from 8 to 120 minutes, more preferably from 10 to 90 minutes and even more preferably from 15 to 60 minutes.
In the inventive manufacturing method, the above-described trimming may be replaced by electrodeposition in which a metal which is the same as or different from the one filled into the through micropores 3 is further deposited only on the surfaces of the metal 4 filled into the through micropores (FIG. 4D).

[Polymer Layer-Forming Treatment]

Polymer layer-forming treatment is a treatment which follows the above-described metal filling treatment to form a polymer layer on at least one surface of the insulating base from which the electrode film has been removed (or the insulating base having undergone surface planarization if this treatment was performed or the trimmed insulating base if trimming treatment was performed). There is no particular limitation on the method of forming the polymer layer, and exemplary methods include a method in which a solution of a polymer in a solvent is applied, and a method in which the insulating base is directly immersed in a solution of a polymer in a solvent and is dried. Of these, in terms of controlling the thickness of the polymer layer to be formed, a solution applying method is preferred and bar coating and spin coating are used with particular advantage.
A method of forming the polymer layer which involves applying a solution containing a monomer and an initiator dissolved in a solvent and performing thermal polymerization or photopolymerization is more preferred.
A solvent used during the polymerization may be used to dissolve the polymer but in the case of using alumina as a preferred insulating base having micropores, an organic solvent in which the alumina is insoluble or poorly soluble is preferably used. Examples of the organic solvent in which the alumina is insoluble or poorly soluble include aliphatic hydrocarbons such as hexane, octane and dodecane; alicyclic hydrocarbons such as cyclohexane; aromatic hydrocarbons such as ethylbenzene, p-xylene, toluene, benzene and tetrahydrofuran; ethers such as diisopropyl ether; alcohols such as methyl alcohol, ethyl alcohol and isobutyl alcohol; ketones such as acetone, diisobutyl ketone, methyl isobutyl ketone, methyl propyl ketone, methyl isopropyl ketone, methyl ethyl ketone and methyl amyl ketone; and esters such as isopropyl acetate, butyl acetate and propyl acetate.
Of these solvents, ketones such as methyl ethyl ketone, diisobutyl ketone, methyl isobutyl ketone, methyl propyl ketone, methyl isopropyl ketone and methyl amyl ketone in which alumina is highly insoluble are preferred.
These solvents are preferably used to dissolve the monomer and the initiator.
The concentration of the polymer and the total concentration of the monomer and the initiator during the dissolution in any of the solvents are preferably from 1 wt% to 50 wt%, more preferably from 3 wt% to 40 wt% and most preferably from 5 wt% to 30 wt%. A lower concentration than the foregoing range is not preferred in the step because a thick layer cannot be formed by a single application process and the solution must be repeatedly applied to form the polymer layer with a predetermined thickness. A higher concentration than the foregoing range is also not preferred because the polymer layer formed has a nonuniform thickness.
In cases where the polymer layer is formed by thermal polymerization or photopolymerization of the applied solution containing the monomer and the initiator, the mixing molar ratio of the monomer to the initiator is preferably from 0.1 to 50.0, more preferably from 0.5 to 30.0 and most preferably from 1.0 to 10.0. A lower mixing ratio than this range leads to a lower degree of polymerization and is therefore not preferred. A higher mixing ratio than this range prevents the polymerization to proceed smoothly and is therefore not preferred.
In cases where the polymer layer containing the conductive material is to be formed, the polymer layer should be formed by reference to (J) Treatment for Forming Conductive Material-Containing Polymer Layer in Example 6 to be described later.
In the polymer layer-forming treatment, in addition to the formation of the polymer layer, a plurality of microstructures can be linked together by the polymer layer. This invention also provides the thus obtained structure in which the microstructures are linked together by the polymer layer.
In cases where a structure in which the microstructures are linked together by the polymer layer is to be manufactured, a plurality of insulating bases from which the electrode film has been removed after metal filling treatment (a plurality of insulating bases having undergone surface planarization if this treatment was performed, or a plurality of insulating bases having undergone trimming treatment if it was performed) are prepared, disposed apart from each other and subjected to polymer layer-forming treatment. Alternatively, an insulating base from which the electrode film has been removed after metal filling treatment (an insulating base having undergone surface planarization if this treatment was performed, or an insulating base having undergone trimming treatment if it was performed) is cut as described below into a plurality of segments, which are then disposed apart from each other and subjected to polymer layer-forming treatment. When manufacturing the structure according to such a procedure, the distance between adjacent insulating bases is the distance between adjacent microstructures in the resulting structure.
In cases where the structure in which the microstructures are linked together by the polymer layer is to be manufactured, the sizes of the individual microstructures and the distance between the microstructures may be arbitrarily selected. The individual microstructures preferably have a size of 1 μm square to 100 cm square and the microstructures are preferably spaced apart from each other by a distance of 1 μm to 10 cm. A smaller size than the foregoing range increases the number of steps, leading to an increase in cost and is therefore not preferred. On the other hand, a larger size than this range reduces the handleability of the structure in which the microstructures are linked together by the polymer layer and is therefore not preferred.

[Cutting]

The microstructure obtained according the above procedure may be cut into a desired size depending on the intended use. Examples of the method that may be used to cut the microstructure include laser processing using a carbon dioxide laser, a YAG laser, a YVO laser, or an excimer laser, dicing using a diamond cutter and water-jet machining. Of these, laser processing and dicing are preferred in terms of the cutting surface state.

EXAMPLES

The present invention is described below more specifically by way of examples. However, the present invention should not be construed as being limited to the following examples.

(Example 1)

(A) Mirror-Like Finishing Treatment (Electrolytic Polishing)

A high-purity aluminum substrate (Sumitomo Light Metal Industries, Ltd.; purity, 99.99 wt%; thickness, 0.4 mm) was cut to a size of 10 cm square that allows it to be anodized, then subjected to electrolytic polishing using an electrolytic polishing solution of the composition indicated below at a voltage of 25 V, a solution temperature of 65°C, and a solution flow velocity of 3.0 m/min.
A carbon electrode was used as the cathode, and a GP0110-30R unit (Takasago, Ltd.) was used as the power supply. In addition, the flow velocity of the electrolytic solution was measured using the vortex flow monitor FLM22-10PCW manufactured by As One Corporation.

(Electrolytic Polishing Solution Composition)

| | |
|---|---|
| 85 wt% Phosphoric acid (Wako Pure Chemical Industries, Ltd.) | 660 mL |
| Pure water | 160 mL |
| Sulfuric acid | 150 mL |
| Methylene glycol | 30 mL |

(B) Anodizing Treatment

After electrolytic polishing, the aluminum substrate was subjected to self-ordering anodizing treatment according to the procedure described in JP 2007-204802 A.
The aluminum substrate having undergone electrolytic polishing was then subjected to 5 hours of preliminary anodizing treatment with an electrolytic solution of 0.50 mol/L oxalic acid under the following conditions: voltage, 40 V; solution temperature, 15°C: and solution flow velocity, 3.0 m/min.
After preliminary anodizing treatment, the aluminum substrate was then subjected to film removal treatment in which it was immersed for 12 hours in a mixed aqueous solution (solution temperature, 50°C) of 0.2 mol/L chromic anhydride and 0.6 mol/L phosphoric acid.
Next, the aluminum substrate was subjected to 10 hours of re-anodizing treatment with an electrolytic solution of 0.50 mol/L oxalic acid under the following conditions: voltage, 40 V; solution temperature, 15°C; and solution flow velocity, 3.0 m/min. An oxide film having a thickness of 80 μm was thus obtained.
Preliminary anodizing treatment and re-anodizing treatment were both carried out using a stainless steel electrode as the cathode and using a GP0110-30R unit (Takasago, Ltd.) as the power supply. Use was made of NeoCool BD36 (Yamato Scientific Co., Ltd.) as the cooling system, and Pairstirrer PS-100 (Tokyo Rikakikai Co., Ltd.) as the stirring and warming unit. In addition, the flow velocity of the electrolytic solution was measured using the vortex flow monitor FLM22-10PCW (As One Corporation).

(C) Aluminum Removal Treatment and Perforating Treatment

Next, the aluminum substrate was dissolved by 3 hours of immersion at 20°C in a 20 wt% aqueous solution of mercuric chloride (corrosive sublimate), in addition to which the bottom of the oxide film was removed by 30 minutes of immersion at 30°C in 5 wt% phosphoric acid, thereby giving an oxide film having through micropores.

(D) Heating treatment

Next, the oxide film (insulating base) having the through micropores obtained above was then subjected to one hour of heating treatment at a temperature of 400°C.

(E) Electrode Film-Forming Treatment

Next, a treatment was carried out for forming an electrode film on one surface of the oxide film having undergone the above-described heating treatment.
To be more specific, an aqueous solution of 0.7 g/L chloroauric acid was applied to one surface, dried at 140°C for 1 minute and further baked at 500°C for 1 hour to form gold plating nuclei.
Then, PRECIOUSFAB ACG2000 base solution/reducing solution (available from Electroplating Engineers of Japan Ltd.) was used as the electroless plating solution to carry out immersion at 50°C for 10 minutes to thereby form the electrode film.

(F) Metal Filling Treatment Step

Next, a copper electrode was placed in close contact with the surface of the oxide film having the electrode film formed thereon, and electrolytic plating was carried out using the copper electrode as the cathode and platinum as the anode.
A mixed solution of copper sulfate/sulfuric acid/hydrochloric acid = 200/50/15 (g/L) held at 25°C was used as the electrolytic solution to carry out constant-voltage pulse electrolysis, thereby filling the through micropores of the oxide film (insulating base) with copper.
An electroplating system manufactured by Yamamoto-MS Co., Ltd. and a power supply (HZ-3000) manufactured by Hokuto Denko Corp. were used to carry out constant-voltage pulse electrolysis. The deposition potential was checked by carrying out cyclic voltammetry in the plating solution, following which the film side potential was set to -2 V and electrolysis was carried out. The pulse waveform in constant-voltage pulse electrolysis was a square waveform. Specifically, electrolysis treatments lasting 60 seconds at a time were carried out a total of five times with 40-second rest periods between the respective treatments, so as to provide a total electrolysis treatment time of 300 seconds.

(G) Surface planarization step

Next, CMP treatment was carried out on the front and back sides of the copper-filled oxide film (insulating base) to polish 15 μm-portions away from both the sides of the 80 μm-thick microstructure, thus removing the electrode film formed on the oxide film. The front and back sides of the oxide film were also planarized to a film thickness of 50 μm.
PLANERLITE-7000 (available from Fujimi Inc.) was used as the CMP slurry.
The surface of the oxide film (insulating base) after CMP treatment was observed by FE-SEM and copper was found to partially protrude from the surface of the oxide film.

(H) Trimming Treatment

The CMP-treated oxide film (isolating base) was then immersed in a phosphoric acid solution so as to selectively dissolve the oxide film, thereby causing the columns of copper filled into the through micropores to protrude from the surface.
The same phosphoric acid solution as in the above-described perforating treatment was used, and the treatment time was set to 5 minutes.

(I) Polymer Layer-Forming Treatment

Then, the solution of the composition indicated below was applied by a spin coater onto one surface of the trimmed oxide film (insulating base) to a dry thickness of 100 μm and dried at 14C°C for 1 minute. Then, the radical polymerizable monomer was photopolymerized by exposure to IR light at 850 nm to form a polymer layer with a thickness of 5 μm on one surface of the oxide film (insulating base). Then, this treatment was repeated twenty times until the polymer layer reached a thickness of 100 μm.
In addition, the surface opposite to the surface on which the polymer layer had been formed was treated in the same manner as above to form a polymer layer with a thickness of 100μm, thus obtaining a microstructure with a size of 10 cm square in Example 1 (FIGS. 5A and 5B).

| | |
|---|---|
| *Radical polymerizable monomer (represented by general formula C, see below) (trade name: A-BPE-20 (m+n≈17), available from Shin-Nakamura Chemical Co., Ltd.) | 0.4120 g |
| * Photothermal conversion agent (represented by general formula D, see below) | 0.0259 g |
| * Radical generator (represented by general formula E, see below) | 0.0975 g |
| * 1-Methoxy-2-prapanol | 3.5800 g |
| * Ethanol | 1.6900 g |

[Chemical Formula 1]

(C)

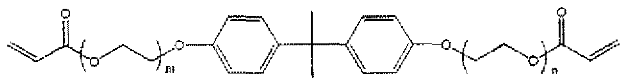

(D)

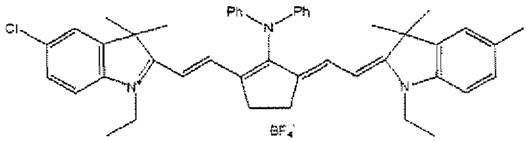

(E)

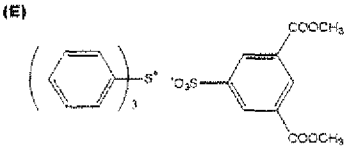

(Example 2)

Example 1 was repeated except that 100 g/L of sodium tetrachloroaurate was used as the electroplating solution to fill gold in (F) Metal Filling Treatment, thereby obtaining a microstructure in Example 2.

(Example 3)

Example 1 was repeated except that 300 g/L of nickel sulfate was used as the electroplating solution to fill nickel in (F) Metal Filling Treatment, thereby obtaining a microstructure in Example 3.

(Example 4)

The microstructure in Example 1 was prepared and allowed to stand in an environment of 25°C and a humidity of 70% for 14 days, thereby obtaining a microstructure in Example 5.

(Example 5)

Example 1 was repeated except that only one surface was subjected to (I) Polymer Layer-Forming Treatment, thereby obtaining a microstructure in Example 5.

(Example 6)

The same treatments as described in the steps (A) to (H) of Example 1 were performed to prepare an oxide film (insulating base) from the surface of which copper filled into the through micropores protruded in a columnar shape.

(J) Treatment for Forming Conductive Material-Containing Polymer Layer

Then, Isopore Membrane Fileter ATTPO 1300 (Nihon Millipore KK) consisting primarily of a polycarbonate

resin was prepared and immersed for 50 seconds in an aqueous solution containing 0.5 wt% of No. 3 sodium silicate heated to 40°C. Then, gold particles were sputtered on one surface of the filter. In addition, PRECIOUSFAB ACG2000 base solution/reducing solution (available from Electroplating Engineers of Japan Ltd.) was used as the electroless plating solution and the filter was immersed in the electroless plating solution at 50°C for 10 minutes to form a gold electrode film.
Subsequently, a copper electrode was placed in close contact with the surface of the oxide film having the electrode film formed thereon, and electrolytic plating was carried out using the copper electrode as the cathode and platinum as the anode.
A mixed solution of copper sulfate/sulfuric acid/hydrochloric acid = 400/50/15 (g/L) held at 50°C was used as the electrolytic solution to carry out electrolytic plating, thereby filling the filter with copper. An electroplating system manufactured by Yamamoto-MS Co., Ltd. and a power supply (HZ-3000) manufactured by Hokuto Denko Corp. were used to carry out electrolytic plating. The deposition potential was checked by carrying out cyclic voltammetry in the plating solution, following which the potential was set to change from 0 V to -2 V at a rate of -1.0 mV/s.
Next, CMP treatment was carried out on the front and back sides of the copper-filled filter to polish 5 μm-portions away from both the sides of the 20 μm-thick filter, thus removing the electrode film formed on the filter. The front and back sides of the filter were also planarized to a thickness of 10 μm.
PLANERLITE-7000 (available from Fujimi Inc.) was used as the CMP slurry.
The surface of the filter after CMP treatment was observed by FE-SEM and the micropores filled with copper could be confirmed.
The thus obtained polymer layer containing copper columns was joined to both surfaces of the above-described oxide film (insulating base), thereby obtaining a microstructure in Example 6.

(Example 7)

The same treatments as described in the steps (A) to (H) of Example 1 were performed to prepare an oxide film (insulating base) from the surface of which copper filled into the through micropores protruded in a columnar shape. Then, the step (K) was followed by the step (L) instead of the step (I) to obtain a structure in Example 7 in which a plurality of microstructures were linked together by the polymer layer.

(K) Cutting

A diamond cutter DAD-322 available from DISCO Corporation was used to divide a 10-cm square oxide film (insulating base) prepared by the same treatments as described in the methods of (A) to (H) of Example 1 into 400 sheets of oxide film (insulating base) with a size of 5 mm square.

(L) Linking Treatment Using Polymer Layer

The 400 sheets of oxide film (insulating base) obtained by the step (K) were disposed in the planar XY directions at intervals of 1 mm so that blocks of 20 sheets were disposed in both of the vertical and horizontal directions. The solution of the composition indicated in (I) was applied by a spin coater onto one surface of the oxide film (insulating base) to a dry thickness of 100 μm and the film was dried at 140°C for 1 minute. Then, the radical polymerizable monomer was photopolymerized by exposure to IR light at 850 nm to form a polymer layer with a thickness of 5 μm on one surface of the oxide film (insulating base). Then, the radical polymerizable monomer was photopolymerized by exposure to IR light at 850 nm to form a polymer layer with a thickness of 5 μm on one surface of the oxide film (insulating base). Then, this treatment was repeated twenty times until the polymer layer reached a thickness of 100 μm. In addition, the surface opposite to the surface on which the polymer layer had been formed was treated in the same manner as above to form a polymer layer with a thickness of 100 μm. A structure in Example 7 was obtained in which 400 sheets of 4-mm square microstructure were disposed at intervals of 1 mm so that blocks of 20 sheets were disposed in both of the vertical and horizontal directions (FIGS. 6A and 6B; note that FIGS. 6A and 6B are simplified views showing the structure in which four microstructures are linked together by the polymer layer so that two microstructures are disposed in both of the vertical and horizontal directions).

(Comparative Examples 1 and 4)

Examples 1 to 4 were repeated except that (I) Polymer Layer-Forming Treatment was omitted, thereby obtaining microstructures in Comparative Examples 1 to 4, respectively.
The thus obtained microstructures in Examples 1 to 6 and Comparative Examples 1 to 4 and structure in Example 7 were evaluated for the metal filling ratio with respect to the through micropores. More specifically, in each of

the thus prepared structures in Examples 1 to 6, Comparative Examples 1 to 4 and Example 7, the surface of the polymer formed was removed by mechanical polishing and observed by SEM to calculate the ratio of the number of micropores filled with copper to the number of all the through micropores within the field of view. The calculation results of the filling ratio in the microstructures in Examples 1 to 6 and Comparative Examples 1 to 4 and structure in Example 7 are shown in Table 1.

The microstructures in Examples 1 to 6 and Comparative Examples 1 to 4 and the structure in Example 7 were also evaluated for the joint strength after thermocompression bonding. More specifically, each of the thus prepared microstructures in Examples 1 to 6 and Comparative Examples 1 to 4 and structure in Example 7 was sandwiched between two 10-mm square gold plates and a pressure of 0.20 MPa was applied at 180°C for 1 minute. The joint strength of the samples after the thermocompression bonding was compared with the tensile strength at the time the gold plates were peeled off from each microstructure. A higher tensile strength indicates a higher joint strength. The results of the microstructures in Examples 1 to 6 and Comparative Examples 1 to 4 and structure in Example 7 are shown in Table 1. The number of days before measurement refers to a number of days for which each microstructure having undergone (I) Polymer Layer-Forming Treatment ((J) Treatment for Forming Conductive Material-Containing Polymer Layer in Example 6; (L) Linking Treatment Using Polymer Layer in Example 7; (F) Metal Filling Treatment in Comparative Examples 1 to 4) was allowed to stand at room temperature before measuring the tensile strength.

The electric resistance was measured at the time each of the microstructures in Examples 1 to 6 and Comparative Examples 1 to 4 and structure in Example 7 was sandwiched between two 10-mm square gold plates and they were joined together. A lower value indicates better conductivity. The results are shown in Table 1.

[Table 1]

| | Filled metal material | Metal filling ratio (%) | Polymer formation | Number of days before measurement (day) | Tensile strength (N) | Electric resistance (Ω) |
|---|---|---|---|---|---|---|
| EX 1 | Cu | 80 | Both surfaces | 0 | 55 | 9.4 |
| EX 2 | Au | 35 | Both surfaces | 0 | 58 | 0.5 |
| EX 3 | Ni | 55 | Both surfaces | 0 | 50 | 1.5 |
| EX 4 | Cu | 80 | Both surfaces | 14 | 53 | 9.7 |
| EX 5 | Cu | 80 | One surface | 0 | 37 | 9.3 |
| EX 6 | Cu | 80 | Both surfaces (containing Cu in columnar shape) | 0 | 180 | 12 |
| EX 7 | Cu | 80 | Both surfaces | 0 | 45 | 13.4 |
| CE 1 | Cu | 80 | No | 0 | 8 | 9.8 |
| CE 2 | Au | 35 | No | 0 | 9 | 0.4 |
| CE 3 | Ni | 55 | No | 0 | 6 | 1.5 |
| CE 4 | Cu | 80 | No | 14 | 2 | 96 |

**Claims**

1. A microstructure comprising an insulating base in which through micropores with a pore size of 10 to 500 nm are disposed at a density of $1 \times 10^6$ to $1 \times 10^{10}$ micropores/mm$^2$, wherein the through micropores are filled with a metal at a filling ratio of at least 30% and a polymer layer is formed on at least one surface of the insulating base.

2. The microstructure according to claim 1, wherein the insulating base is an alumina base obtained by anodizing aluminum.

3. The microstructure according to claim 1 or 2, wherein a degree of ordering of the through micropores as defined by

formula (i) :

$$\text{Degree of ordering (\%)} = B/A \times 100 \quad (i)$$

(wherein A represents a total number of through micropores in a measurement region, and B represents a number of specific through micropores in the measurement region for which, when a circle is drawn so as to be centered on a center of gravity of a specific through micropore and so as to be of a smallest radius that is internally tangent to an edge of another through micropore, the circle includes centers of gravity of six through micropores other than the specific through micropore) is at least 50%.

**4.** The microstructure according to any one of claims 1 to 3, wherein the metal filled into the through micropores is exposed at surfaces of the insulating base.

**5.** The microstructure according to any one of claims 1 to 3, wherein the metal filled into the through micropores is protruded from surfaces of the insulating base.

**6.** A method of manufacturing a microstructure according to any one of claims 1 to 5, comprising at least:

(1) a treatment for forming an electrode film having no void on one surface of an insulting base in which through micropores with a pore size of 10 to 500 nm are disposed at a density of $1 \times 10^6$ to $1 \times 10^{10}$ micropores/$mm^2$;
(2) a metal filling treatment through electrolytic plating using the electrode film; and
(3) a treatment for forming a polymer layer,
these treatments being performed in this order.

**7.** A structure obtained by linking together a plurality of microstructures according to any one of claims 1 to 5 via a polymer layer.

FIG.1A

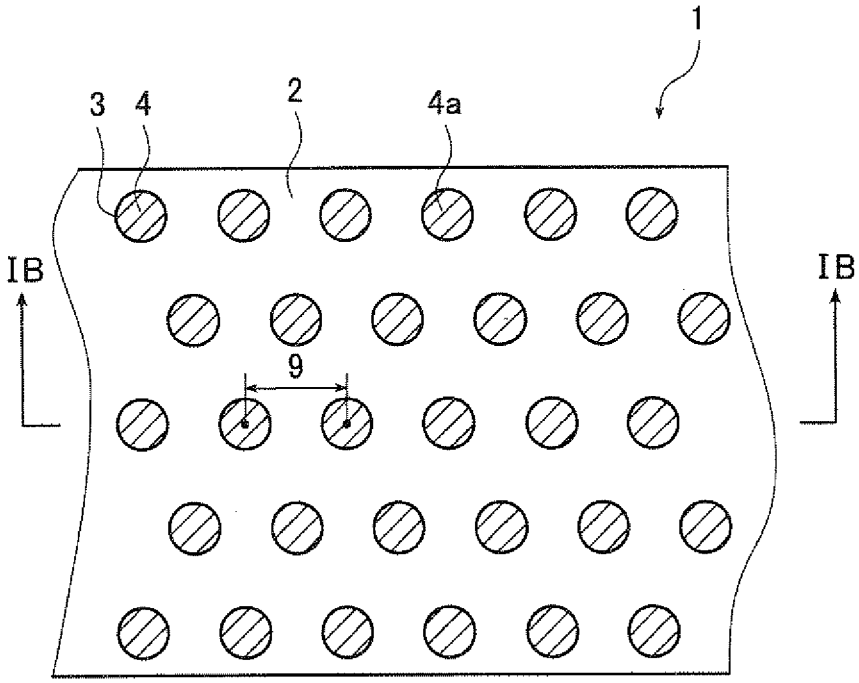


FIG.1B

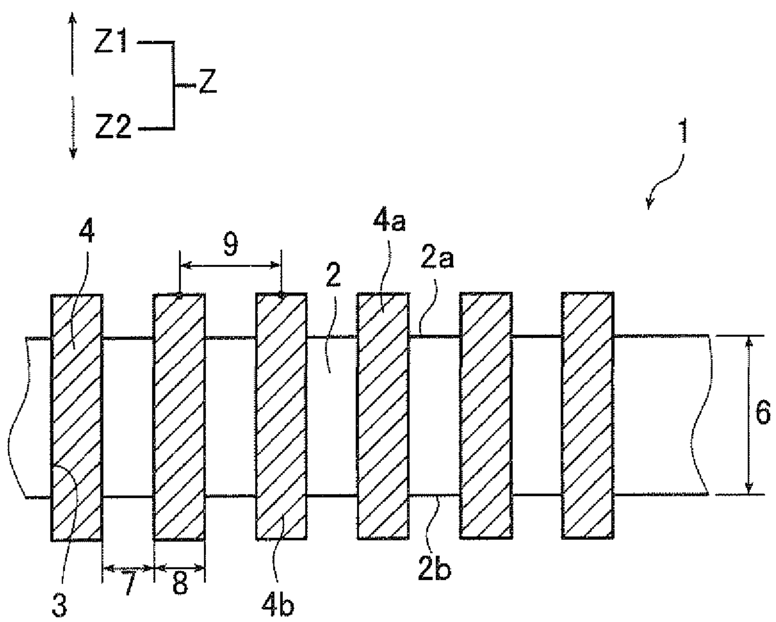

FIG.2A

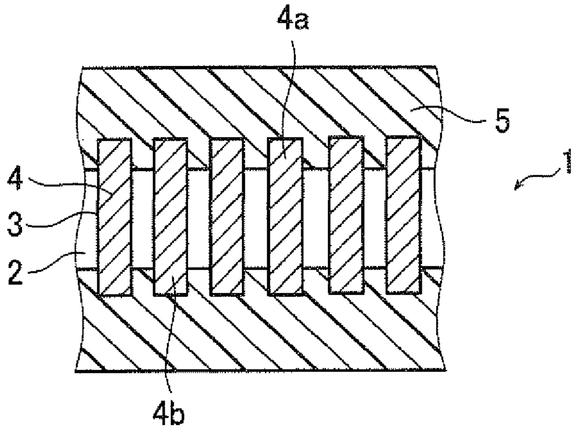


FIG.2B

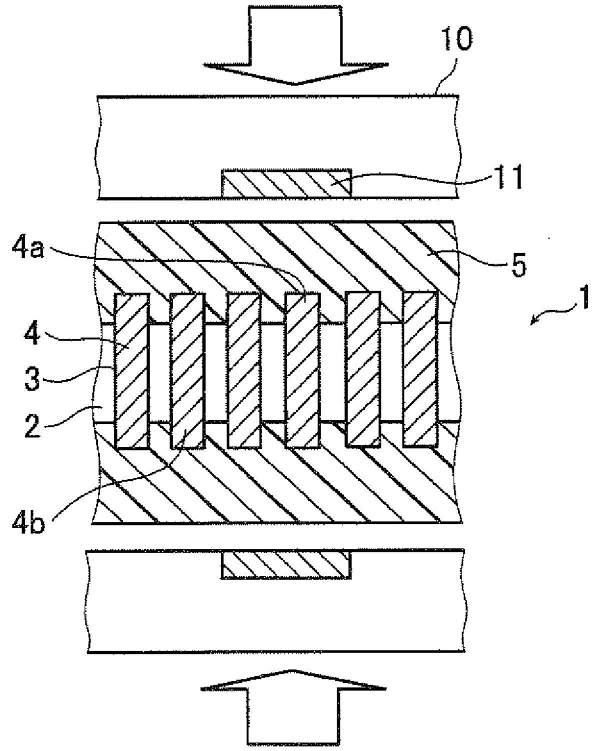


FIG.2C

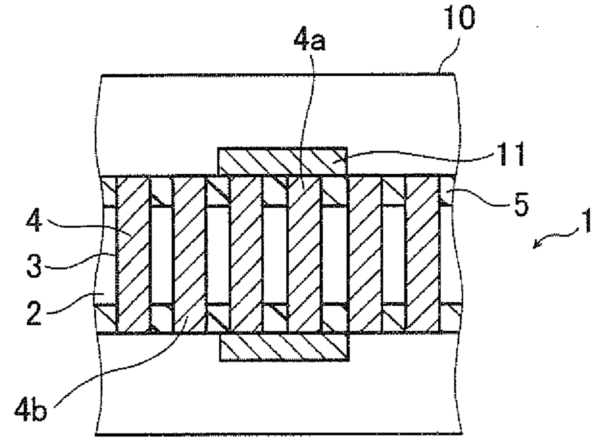

FIG.3A

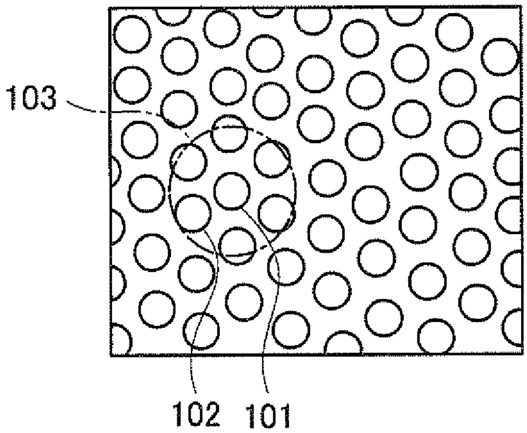


FIG.3B

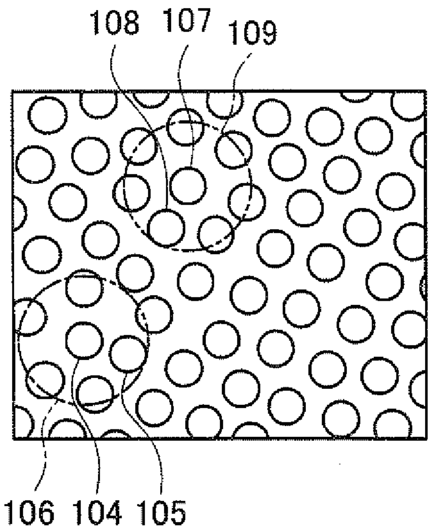


FIG.4A

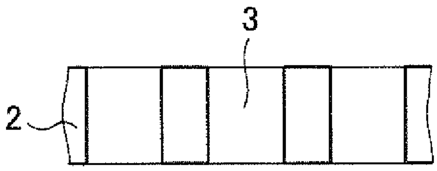


FIG.4B

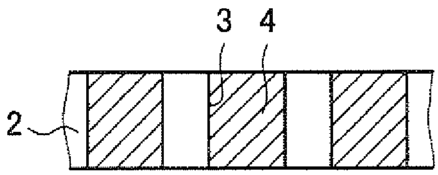


FIG.4C

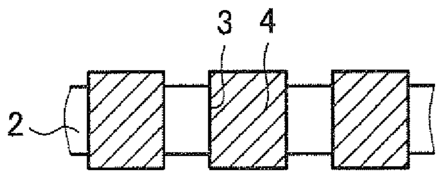


FIG.4D

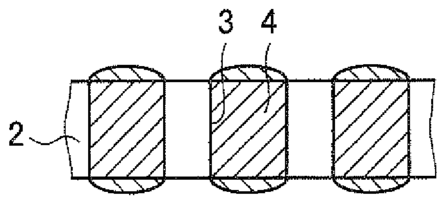

FIG.5A

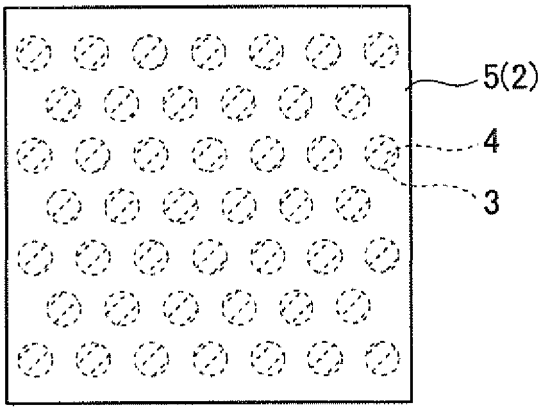


FIG.5B

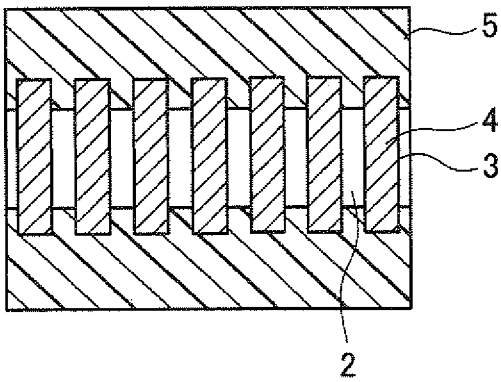

FIG.6A

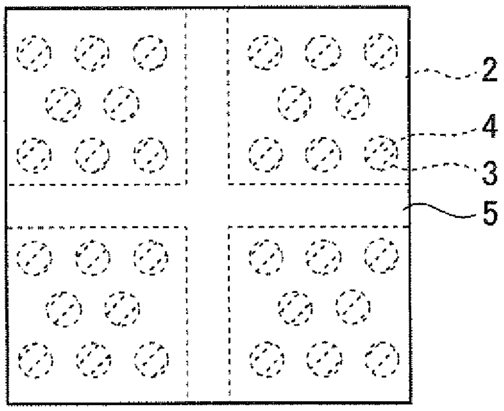


FIG.6B

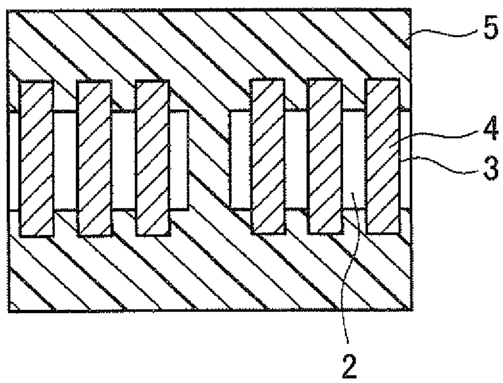

## INTERNATIONAL SEARCH REPORT

International application No.
PCT/JP2009/062350

A. CLASSIFICATION OF SUBJECT MATTER
*H01B5/16*(2006.01)i, *H01B13/00*(2006.01)i, *H01L21/60*(2006.01)i, *H01R11/01*(2006.01)i, *H05K1/14*(2006.01)i

According to International Patent Classification (IPC) or to both national classification and IPC

B. FIELDS SEARCHED

Minimum documentation searched (classification system followed by classification symbols)
H01B5/16, H01B13/00, H01L21/60, H01R11/01, H05K1/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2004-143524 A (Matsushita Electric Industrial Co., Ltd.), 20 May, 2004 (20.05.04), Par. Nos. [0018] to [0038]; Figs. 1 to 5 (Family: none) | 1,2,4-7 |
| Y | JP 62-117207 A (Minnesota Mining & Manufacturing Co.), 28 May, 1987 (28.05.87), Page 4, lower right column, line 8 to page 6, upper right column, line 14; Figs. 1 to 5 & EP 223464 A2 & AU 6383586 A & BR 8605417 A & CA 1273417 A & CN 86106351 A & AU 6383586 A1 | 1,2,4-7 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 31 July, 2009 (31.07.09) | 11 August, 2009 (11.08.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2009/062350

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2007-335851 A (Matsushita Electric Industrial Co., Ltd.), 27 December, 2007 (27.12.07), Par. Nos. [0036] to [0037]; Figs. 1 to 8 & US 2007/0262447 A1 | 2,4-7 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000012619 A
- JP 2005085634 A
- JP 2002134570 A
- JP 3182081 A
- US 2708655 A
- JP 3714507 B
- JP 2002 A
- JP 285382 A
- JP 2006124827 A
- JP 2007204802 A
- JP 2007231339 A
- JP 2007231405 A
- JP 2007231340 A
- JP 2007238988 A
- JP 10121292 A
- JP 2001105400 A
- JP 2003129288 A


### Non-patent literature cited in the description


- Aluminum Handbook. Japan Aluminum Association, 2001, 164-165
- **Jitsumu Hyomen Gijutsu.** *Practice of Surface Technology,* 1986, vol. 33 (3), 32-38